Europäisches Patentamt

European Patent Office

Office européen des brevets

(11) Veröffentlichungsnummer: **0 398 135**

**A2**

(12) **EUROPÄISCHE PATENTANMELDUNG**

(21) Anmeldenummer: **90108691.8**

(22) Anmeldetag: **09.05.90**

(51) Int. Cl.⁵: **H01L 33/00, H01S 3/18, H05B 33/14**

(30) Priorität: **13.05.89 DE 3915701**

(43) Veröffentlichungstag der Anmeldung:
**22.11.90 Patentblatt 90/47**

(84) Benannte Vertragsstaaten:
**AT BE CH DE DK ES FR GB GR IT LI LU NL SE**

(71) Anmelder: **Forschungszentrum Jülich GmbH**
**Postfach 1913, Wilhelm-Johnen-Strasse**
**D-5170 Jülich(DE)**

Anmelder: **FRAUNHOFER-GESELLSCHAFT**
**ZUR FÖRDERUNG DER ANGEWANDTEN**
**FORSCHUNG E.V.**
**Leonrodstrasse 54**
**D-8000 München 19(DE)**

(72) Erfinder: **Lüth, Hans, Prof, Dr.**
**Eupener Strasse 299b**
**D-5100 Aachen(DE)**
Erfinder: **Müller, Harald D.**
**Winterhaldenweg 68**
**D-7824 Hinterzarten(DE)**
Erfinder: **Schneider, Jürgen, Prof., Dr.**
**Neuhäuserstrasse 62**
**D-7815 Kirchzarten(DE)**
Erfinder: **Strümpler, Ralf**
**Parkstrasse 29**
**CH-5400 Baden(DE)**

(54) Optoelektronisches Bauelement.

(57) Die Erfindung bezieht sich auf ein Optoelektronisches Bauelement mit Si- oder III-V-Halbleiter-Schicht und Dotierung mit Lanthaniden zur Erzeugung eines opischen Signals, dessen Wellenlänge durch das 4f-Ion bestimmt ist. Es ist Aufgabe der Erfindung, ein derartiges Bauelement zu schaffen, daß aus Si-oder III-V Halbleitermaterialen integrierbar ist. Erfindungsgemäß ist hierzu eine auf die Si- oder Halbleiter-Schicht aufgewachsene Fluoridschicht vorgesehen, in die Lanthanid-Ionen eingebaut sind. Die Fluoridschicht kann dabei sowohl polykristallin als auch epitaktisch auf die Schicht aufgewachsen sein.

## Optoelektronisches Bauelement

Die Erfindung bezieht sich auf ein optoelektronisches Bauelement mit Isolator und Dotierung mit Lanthaniden zur Erzeugung eines optischen Signals, dessen Wellenlänge durch das 4f-Ion (Lanthanid) bestimmt ist.

Im Rahmen der modernen Informationstechnologie spielen optoelektronische Bauelemente eine überragende Rolle; sie bilden das verbindende Glied zwischen dem Nachrichtenträger (Glasfaser) und der Verarbeitungsstation, die weitgehend auf der Grundlage der Halbleiterelektronik basiert. Optoelektronische Bauelemente wandeln optische in elektrische Signale und umgekehrt um. Während nun der überaus größere Teil mikroelektronischer Schaltkreise in Siliciumtechnologie hergestellt wird, erfordert die Schnittstelle Licht/elektrische Signale, d. h. das optoelektronische Bauelement, die Verwendung von III/V-Halbleiterbauelementen wie Laser, Leuchtdioden etc. Dies liegt daran, daß die für optoelektronische Bauelemente wichtigen, direkten (d. h. stark ankoppelnden) elektronischen Übergänge zwischen Leitungs- und Valenzband bei Silicium im Gegensatz zu vielen III/V-Halbleitern normalerweise nicht zum Leuchten angeregt werden können.

Als Stand der Technik ist es aus "Optics and Spectroscopy" 26 (1969), Seite 176 sowie "J. Appl. Phys. 44 (1973), Seiten 5029 - 5030 bekannt, eine Fluorid schicht, z. B. $CaF_2$ und $CdF_2$, mit dem Seltenen Erd-Element Tb bzw. Gd zu dotieren. Die bei der Dotierung mit Lanthaniden (4f-Ionen) verbundene Verbindung der Seltenen-Erd-Spektrallinie besitzt Vorteile gegenüber der Emissionslinie einer III/V-Halbleiter-Leuchtdiode oder eines Lasers, da die Rumpf-Niveau-Emissionslinie der Seltenen-Erden schärfer ist als die wegen der merklichen Breite der Valenzleitungsbandszustandsdichten breitere Laser-Linie. Außerdem entfallen durch die Dotierung mit Lanthaniden Probleme, die auf thermische Schwankungen zurückzuführen sind.

Die Anregung des 4f-Übergangs kann durch Elektronenbeschuß (Kathodolumineszenz), durch elektrische Anregung bei Stromfluß (Elektrolumineszenz, über zwei Kontakte in Diodenanordnung) oder durch Lichteinstrahlung, z. B. mittels eines Halbleiter-Lasers geschehen, der in seiner Emissionslinie auf die Anregungsenergie des Intra-f-Schalenübergangs abgestimmt ist. Die Rekombination der bei der Anregung erzeugten Elektron-Lochpaare am Seltenen-Erd-Ion führt zur Ausstrahlung einer energetisch, relativ scharfen Spektrallinie.

Es ist daher Aufgabe der Erfindung, ein optoelektronisches Bauelement der eingangs bezeichneten Art zu schaffen, das eine intensitätsstarke und spektralscharfe Emission besitzt.

Diese Aufgabe wird erfindungsgemäß dadurch gelöst, daß als Isolator eine Metallverbindung mit wenigstens einer Metallkomponente vorgesehen ist und zur Erzeugung des optischen Signals im Isolator Lanthanid-Ionen eingebaut sind, wobei die Wertigkeit dieser Lanthanid-Ionen mit der Wertigkeit wenigstens einer der Metallkomponenten im Isolator übereinstimmt.

Beim Stand der Technik bei Elektrolumineszenz der dreiwertigen Seltenen-Erde, wie beim $Tb^{3+}$, im zweiwertigen Wirtskristall, insbesondere $CaF_2$, kommt es, da die Ladungskompensation fehlt, nachteilig zu einer Vielzahl von assoziierten Defekten. Dies führt zu breiten, komplexen Lumineszenzspektren der Spin -aufgespaltenen 4f-Niveau Übergänge der Seltenen Erde.

Demgegenüber wird bei der technischen Lehre durch die Übereinstimmung der Wertigkeiten der Lanthanid-Ionen und der Metallkomponente im Isolator ein stöchiometrischer, substitutioneller Einbau der Lanthanid-Ionen ohne Komplexbildung bzw. Defektbildung ermöglicht. Selbstverständlich setzen die Wertigkeiten voraus, daß der Isolator zumindest in der Nahordnung einen überwiegend ionischen Charakter der chemischen Bindung besitzt und daß die lokale Gitterstruktur des Seltenen Erd-Ions mit der lokalen Gitterstruktur des Metallions ähnlich ist, was durch nicht zu stark abweichende Ionenradien der beteiligten Ionen erreicht wird. Aus diesem Grunde kommen solche Materialien, die eine stark kovalente Bindung haben, wie z.B. GaAs, als Isolator im Sinne der gegebenen Lehre nicht in Frage.

Es wird darauf hingewiesen, daß es physikalisch nicht sinnvoll ist, den Isolator von einem Halbleiter zu unterscheiden. In beiden Fällen liegt ein sgn. "Gap" zwischen Valenz- und Leitungsband vor, dessen Wertabnahme für die Abnahme des Isolatorcharakters des Materials zugunsten ihres Halbleitercharakters verantwortlich ist.

Zweckmäßigerweise wird der Isolator schichtförmig ausgebildet. Im Bereich der integrierten Schaltungen ist in Ausbildung der Erfindung eine vorteilhafte Variante des Bauelements dadurch gegeben, daß der Isolator mit einer Si-, III/V-Halbleiter- oder II/VI-Halbleiterschicht fest verbunden ist. Selbstverständlich ist man dabei nicht auf binäre Halbleiter beschränkt. Vielmehr kommen hier auch ternäre oder quarternäre Halbleitersysteme wie z. B. $In_{1-x}Ga_xAs_yP_{1-y}$ in Frage.

In Ausbildung der Erfindung ist ein epitaktisch aufgewachsener Isolator vorteilhaft. Insbesondere sind die Metallfluoride $CaF_2$, $LaF_3$ oder $XF_x$ (wobei X eine Metallkomponente aus der Reihe der Selten-Erd-Metalle ist) dabei zu nennen. Auch hier ist das Isolatormaterial keineswegs auf binäre System beschränkt: insbesondere die Systeme $Ca_xSr_{1-x}F_2$ oder $La_{1-x}X_xF_3$ sind hier als Isolator zu nennen. Es wäre allerdings auch denkbar als Isolator Chloride oder andere Halogenide einzusetzen. Im übrigen seien als mögliche Isolatormaterialen auch noch ZnO, $CdF_2$, $In_2O_3$ sowie Indium-Zinnoxid (ITO) erwähnt.

Zweckmäßigerweise ist insbesondere eine epitaktische Abscheidung solcher Isolatormaterialien auf Si (100)-oder Si (111)-Schichten. Dabei empfiehlt sich das epitaktische Abscheiden einer Isolatorschicht aus einem Material, das als Metallkomponente ein Selten Erdmetall, insbesondere La, enthält, auf einer Si (100)-Schicht. So ist es beispielsweise möglich, lichtemittierende Dioden auf Si herzustellen, indem Fluoridschichten mit Seltenen-Erd-Ionen substituiert werden, wie beispielsweise Er oder Nd (oder auch Doppeldotierungen wie Er mit Yb) und auf einem Silicium-Wafer abgeschieden werden. Der Stromfluß zwischen einem auf der Fluoridschicht abgeschiedenen Metallfilm und dem Si-Substrat regt die in der Fluoridschicht substituierte Lanthanide zur Aussendung der starken und scharfen Spektrallinie an.

Im Falle wenigstens einer dreiwertigen Metallkomponente im Isolator ist es vorteilhaft, als dreiwertige Lanthanid-Ionen wenigstens eines der Elemente aus der Gruppe Nd, Gd, Dy, Ho und Er zu wählen, insbesondere Er und Nd. Im Falle wenigstens einer zweiwertigen Metallkomponente ist eine Dotierung mit wenigstens einer der Elemente aus der Gruppe Sm, Eu, Tm und Yb vorteilhaft. Keineswegs ist unter Einhaltung der übereinstimmenden Wertigkeiten zwischen den Dotierungsionen und der Metallkomponente(n) die Dotierung des Isolators auf Ionen eines einzigen Elementes beschränkt. Vielmehr kann der Einbau von Lanthanid-Ionen unterschiedlicher Elemente dazu führen, daß in Ausbildung der Erfindung in besonders vorteilhafter Weise im Bauelement mehrere optische Signale unterschiedlicher Wellenlängen mit hoher Intensität und schärfster Emissionsstruktur ermöglicht werden. Dabei ist es vorstellbar, daß in einem einzigen Bauelement dieser Art mehrere parallele optische Signale unterschiedlicher Wellenlänge in einer einzigen, integrierten Schaltung selektiv weiter verarbeitet werden.

Eine variante Ausführungsform der Erfindung besteht darin, daß der Isolator sich zwischen Si-Schichten oder III/V-Halbleiterschichten befindet. Wenn wenigstens eine der Si-Schichten bzw. III/V-Halbleiterschichten auf den Isolator epitaktisch aufgewachsen ist, liegt eine besonders vorteilhafte Ausführungsform der Erfindung vor.

Zweckmäßig kann eine Ausführungsart mit einem Mehrfachschichtpaket sein, bei dem die Dik-ken der abwechselnd aufeinanderaufgewachsenen Isolatoren und Halbleiterschichten jeweils eine Dikke von λ/2 der ausgesandten Lichtwelle haben. In vorteilhafter Weise können die Isolatoren und Halbleiterschichten epitaktisch aufeinander aufgewachsen sein. Wegen der Möglichkeit einer solchen wechselseitigen Epitaxie können aus diesen Materialien Übergitter hergestellt werden, die den Bau von planaren "distributed feed-back" lichtemittierenden Dioden oder Lasern ermöglichen, wobei die Lichtaussendung senkrecht zur Schichtfolge geschieht.

Um eine gerichtete Lichtausstrahlung senkrecht zur Schichtenfolge zu bewirken, ist es zweckmäßig, daß aus Interferenzgründen die Schichtdicke jeweils λ/2 der ausgesandten Lichtwellenlänge beträgt. Hierbei ist λ die für das jeweilige Medium durch den Brechungsindex korrigierte Wellenlänge.

Bei einer weiteren vorteilhaften Ausführungsform des Bauelementes gemäß der Erfindung ist der Isolator zur Bildung eines Resonators benachbart zu der III/V-Halbleiterschicht (oder ggfs. einer II/VI-Halbleiterschicht) auf einem III/V-Substrat (ggfs. auch auf einem Si- oder II/VI-Substrat) aufgewachsen, das beispielsweise aus GaAs, InP, GaAlAs oder CdS besteht. Ein solcher Resonator dient der "Stabilisierung" eines Halbleiter-Lasers in der integrierten Optik, da die abgeschiedene Isolatorschicht (beispielsweise mit Er-Ionen substituiert) aus der relativ breiten Laser-Linie eine schmale, thermisch stabile Spektrallinie "heraussiebt". Die elektronischen Übergänge werden dabei optisch durch die Laser-Linie angeregt, wobei die Emission der Resonator-Laser-Kombination im wesentlichen mit der Spektrallinie der Lanthanidionen erfolgt.

Ausführungsarten des optoelektronischen Bauelements gemäß der Erfindung sind in der Zeichnung schematisch dargestellt und werden im folgenden näher erläutert:

Es zeigen

Figur 1 lichtemittierende Diode auf Silicium-Basis;

Figur 2 zwischen zwei Si-Elektroden integrierte Diode;

Figur 3 Bauelement, bestehend aus einer Vielzahl von Schichtpaaren;

Figur 4 Bauelement, ausgebildet als Resonator zur Stabilisierung eines Halbleiter-Lasers.

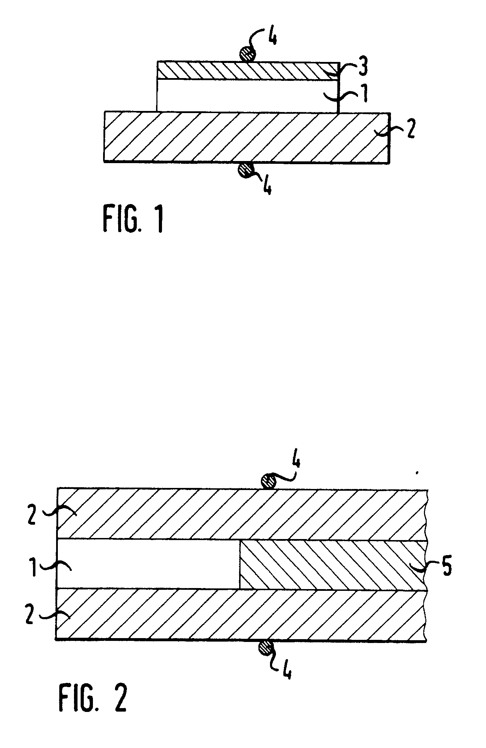

Bei der in Figur 1 dargestellten Diode ist die Isolatorschicht 1 auf einem Si-Wafer 2 epitaktisch aufgewachsen. Auf der Isolatorschicht, die beispielsweise mit Er substituiert ist, ist ein Metallfilm 3 als Elektrode abgeschieden, die mit einem der Kontakte 4 in Verbindung steht.

Die in Figur 2 dargestellte Diode weist zwei, mit Kontakt 4 verbundene, niederohmige Si-Schichten auf, zwischen denen sich die epitaktische Isolatorschicht 1 befindet. Die Isolatorschicht ist eine hochohmige Si-Schicht 5 benachbart.

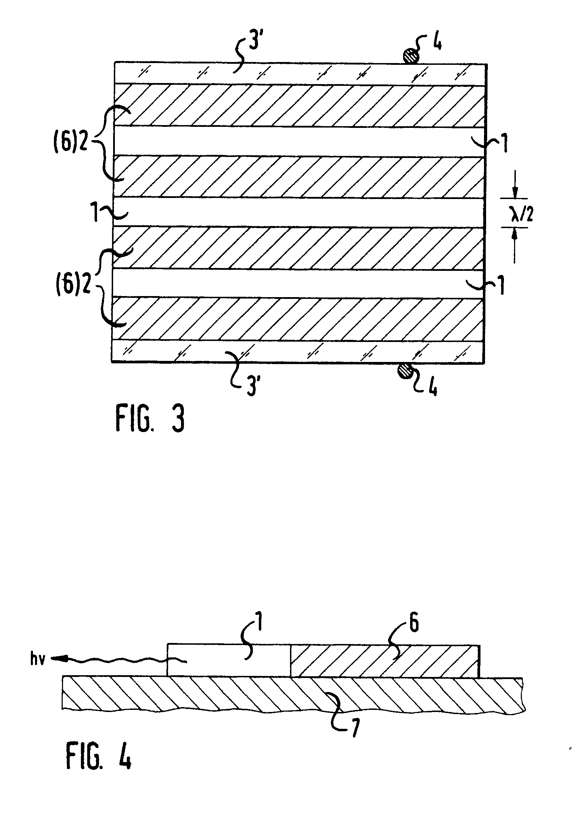

Das in Figur 3 wiedergegebene Bauelement besteht aus mehreren Schichtpaaren - es können zwischen 10 und 100 Schichtpaare sein -, bestehend jeweils aus epitaktischer Isolatorschicht und Si-Schicht 2 bzw. - zur Bildung eines Lasers - III/V-Halbleiterschicht 6. Das Schichtenpaket ist durch transparente Elektroden 3' begrenzt, die mit den Kontakten 4 in Verbindung stehen.

Figur 4 zeigt die auf dem III/V-Substrat 7, beispielsweise GaAs oder InP epitaktisch aufgewachsene, Lanthanid-substituierte Isolatorschicht 1, die der III/V-Halbleiterlaserschicht 6 benachbart ist.

Die Herstellung der beschriebenen Ausführungsformen des Bauelementes gemäß der Erfindung geschah in einer Molekularstrahl-Epitaxieanlage, wo entweder Si oder III/V-Halbleiterschichtsysteme in einer UHV-Umgebung abgeschieden werden. Die für die Abscheidung der Isolatorschicht vorgesehene Fläche muß "rein"-präpariert werden, durch Epitaxie oder durch Ionenbeschuß und Anlassen. Dann wird die Isolatorschicht abgeschieden, indem das pulverisierte Gemisch, z.B. aus $LaF_3$/Er (abgewogen ensprechend der At%), aus einem Tiegel oder einem Schiffchen verdampft wird. Für polykristalline Isolatorschichten ist die Präparation der Si-oder III/V-Halbleiter- oder II/VI-Halbleiteroberfläche weniger kritisch.

**Ansprüche**

1. Optoelektronisches Bauelement mit Isolator (1) und Dotierung mit Lanthaniden zur Erzeugung eines optischen Signals, dessen Wellenlänge durch das 4f-Ion (Lanthanid) bestimmt ist,
**dadurch gekennzeichnet,**
daß

a) als Isolator (1) eine Metallverbindung mit wenigstens einer Metallkomponente vorgesehen ist,

b) zur Erzeugung des optischen Signals Lanthanid-Ionen, deren Wertigkeit mit der Wertigkeit wenigstens einer der Metallkomponente übereinstimmt, im Isolator eingebaut sind.

2. Optoelektronisches Bauelement nach Anspruch 1,
**dadurch gekennzeichnet,**
daß der Isolator (1) schichtförmig ist.

3. Optoelektronisches Bauelement nach Anspruch 1 oder 2,
**dadurch gekennzeichnet,**
daß der Isolator (1) mit einer Si-, III-V-Halbleiter- oder II-VI-Halbleiterschicht (2) fest verbunden ist.

4. Optoelektronisches Bauelement nach einem der Ansprüche 1 bis 3,
**dadurch gekennzeichnet,**
daß der Isolator (1) epitaktisch aufgewachsen ist.

5. Optoelektronisches Bauelement nach einem der vorhergehenden Ansprüche,
**dadurch gekennzeichnet,**
daß als Isolator (1) $CaF_2$, $In_2O_3$, ITO, $LaF_3$ oder $XF_{x-}$ (X = Ce, Pr, Nd, Pm, Sm, Eu, Gd, Tb, Dy, Sc, Y, Ho, Er, Tm, Yb, Lu) vorgesehen ist.

6. Optoelektronisches Bauelement nach einem der Ansprüche 1 bis 4,
**dadurch gekennzeichnet,**
daß als Isolator (1) $Ca_xSr_{1-x}F_2$ oder $La_{1-x}X_xF_3$ (X = La, Ce ... Yb, Lu wie auch Scandium und Yttrium) vorgesehen ist.

7. Optoelektronisches Bauelement nach einem der vorhergehenden Ansprüche,
**dadurch gekennzeichnet,**
daß der Isolator (1) auf ein Si (100)-oder Si (111)-Schicht (2) aufgewachsen ist.

8. Optoelektronisches Bauelement nach einem der vorhergehenden Ansprüche,
**dadurch gekennzeichnet,**
daß als Dotierung dreiwertige Ionen wenigstens eines der Elemente aus der Gruppe, bestehend aus Nd, Gd, Dy, Ho und Er vorgesehen sind.

9. Optoelektronisches Bauelement nach einem der Ansprüche 1 bis 7,
**dadurch gekennzeichnet,**
daß als Dotierung zweiwertige Ionen wenigstens eines der Elemente aus der Gruppe, bestehend aus Sm, Eu, Tm und Yb vorgesehen sind

10. Optoelektronisches Bauelement nach einem der vorhergehenden Ansprüche,
**dadurch gekennzeichnet,**
daß der Isolator (1) sich zwischen Si-Schichten (2) befindet.

11. Optoelektronisches Bauelement nach Anspruch 10,
**dadurch gekennzeichnet,**
daß wenigstens eine der Si-Schichten (2) auf den Isolator (1) epitaktisch aufgewachsen ist.

12. Optoelektronisches Bauelement nach einem der vorhergehenden Ansprüche
**dadurch gekennzeichnet,**
daß der Isolator (1) sich zwischen III-V-Halbleiterschichten (2) befindet.

13. Optoelektronisches Bauelement nach Anspruch 12,
**dadurch gekennzeichnet,**
daß wenigstens eine der III-V-Halbleiterschichten (2) auf den Isolator (1) epitaktisch aufgewachsen ist.

14. Optoelektronisches Bauelement nach einem der Ansprüche 10 bis 13,
**dadurch gekennzeichnet,**
daß ein Mehrfachschichtpaket vorliegt, bei dem die Dicken der abwechselnd aufeinander aufgewachsenen Isolatoren (1) und Halbleiterschichten (2) jeweils eine Dicke von $\lambda/2$ der ausgesandten Lichtwellenlänge haben.

15. Optoelektronisches Bauelement nach Anspruch 14,
**dadurch gekennzeichnet,**
daß wenigstens eine der Isolatoren (1) oder Halbleiterschichten (2) epitaktisch aufgewachsen ist.

16. Optoelektronisches Bauelement nach einem der vorhergehenden Ansprüche,
**dadurch gekennzeichnet,**
daß der Isolator zur Bildung eines Resonators benachbart zu der Licht emittierenden III-V-Halbleiterschicht (z. B. Laser-Struktur) auf einem Si-, II-VI-
oder III-V-Substrat (6,7) aufgewachsen ist.

17. Optoelektronisches Bauelement nach Anspruch 16,
**dadurch gekennzeichnet,**
daß das III-V-Substrat (7) aus GaAs, GaAlAs oder
InP besteht.

18. Optoelektronisches Bauelement nach Anspruch 16,
**dadurch gekennzeichnet,**
daß das II-VI-Substrat (7) aus CdS besteht.

FIG. 1

FIG. 2

FIG. 3

FIG. 4